# EUROPEAN PATENT SPECIFICATION

(11) **EP 2 393 107 B1**
(45) Date of publication and mention of the grant of the patent: **16.01.2013**
(21) Application number: 11004317.1
(22) Date of filing: 25.05.2011
(51) Int. Cl.: H01L 29/786, H01L 29/66

(54) **Field effect transistor manufacturing method and semiconductor graphene oxide manufacturing method**
Verfahren zur Herstellung eines Feldeffekttransistors und Verfahren zur Herstellung von Halbleiter-Graphenoxid
Procédé de fabrication de transistor à effet de champ et procédé de fabrication d'oxyde de graphène semi-conducteur

(30) Priority: 01.06.2010 JP 2010125653; 26.11.2010 JP 2010263171
(43) Date of publication of application: 07.12.2011
(73) Proprietor: Sony Corporation, Tokyo 108-0075 (JP)
(72) Inventor: Kobayashi, Toshiyuki, Tokyo 108-0075 (JP)
(74) Representative: Müller - Hoffmann & Partner

(56) References cited:
- WO-A1-2009/085015
- US-A1- 2009 235 721
- US-A1- 2010 028 681
- XIAOZHU ZHOU ET AL.: "A Method for Fabrication of graphene Oxide Nanoribbons from Graphene Oxide Wrinkles", JOURNAL PHYS. CHEM. C, vol. 113, 9 October 2009 (2009-10-09), pages 19119-19122, XP000002658956,

## Description

### FIELD

The present disclosure relates to a field effect transistor manufacturing method, a field effect transistor, and a semiconductor graphene oxide manufacturing method, and more particularly, a field effect transistor including semiconductor graphene oxide used for a channel layer.

### BACKGROUND

In recent years, research and development for a field effect transistor including a channel layer formed using semiconductor graphene have been carried out. In the related art, there have been proposed several methods of forming semiconductor graphene. The first method is to form graphene oxide on a substrate and then heat and reduce the graphene oxide at the temperature of 120° to 240° (see "Tunable Electrical Conductivity of Individual Graphene Oxide Sheets Reduced at "Low" Temperatures," Nano Letters 8, 4283 (2008) (non-patent document 1)). The second method is to form graphene oxide on a substrate and then chemically reduce the graphene oxide with hydrazine (see "Insulator to Semimetal Transition in Graphene Oxide," J. Phys. Chem. C 113, 15768 (2009) (non-patent document 2)). The third method is to form a thin a graphene sheet at a width of about 10 nm to form semiconductor graphene (see "Energy Band-Gap Engineering of Graphene Nanoribbons," Phys. Rev. Lett. 98, 206805 (2007) (non-patent document 3) and "Chemically Derived, Ultrasmooth Graphene Nanoribbon Semiconductors," Science 319, 1229 (2008) (non-patent document 4)). The fourth method is to apply an electric field in a two-layered graphene stacking direction to form semiconductor graphene (see "Direct observation of a widely tunable bandgap in bilayer graphene," Nature 459, 820 (2009) (non-patent document 5)).

### SUMMARY

However, the method disclosed in the non-patent document 1 may obtain just semimetallic reduced graphene oxide having no band gap Eg by the heating and reduction of the graphene oxide but may not obtain semiconductor graphene oxide having a finite band gap. This may result in a small on/off ratio of about 3 of a field effect transistor (FET) using this reduced graphene oxide for a channel layer, high power consumption of a logic circuit if it employs such a FET, a small contrast ratio of a backplane of a display if it employs such a FET, etc.

In addition, in the method disclosed in the non-patent document 2, the obtained reduced graphene oxide has a small band gap Eg of 0.055 eV and is insufficient to be used as a channel layer of a field effect transistor. In addition, the method disclosed in the non-patent document 3 needs to use expensive state-of-the-art lithography or may have poor yield of products and high unevenness of products.

In addition, the method disclosed in the non-patent document 5 creates a complicated device structure since there exists no current technique for uniformly forming two-layered graphene on the entire surface and a high electric field must be continuously applied.

In this manner, the above-mentioned related semiconductor graphene forming methods have their advantages and disadvantages.

Accordingly, it is desirable to provide a field effect transistor manufacturing method of manufacturing a field effect transistor having a large on/off ratio and a simple structure using semiconductor graphene oxide at low cost and with high yield.

It is also desirable to provide a field effect transistor having a large on/off ratio and a simple structure using semiconductor graphene oxide.

It is also desirable to provide a semiconductor graphene oxide manufacturing method of manufacturing semiconductor graphene oxide having a sufficiently large band gap Eg at low cost and with high yield.

The above and other needs will be more apparent in the following description.

According to the present embodiments as defined in the claims, it is possible to obtain semiconductor graphene oxide having a sufficiently large band gap Eg by forming a molecular layer including molecules having amino groups on a substrate, forming graphene oxide, and then reducing the graphene oxide.

In an embodiment of the present invention, a method of manufacturing a film includes forming a base layer including amino groups, and forming a reduced graphene oxide layer on the base layer. The reduced graphene oxide layer is formed by thermally reducing graphene oxide. The reduced graphene oxide layer is formed by reducing graphene oxide by heat treatment at a temperature of equal to or more than 100°C and equal to or less than 400°C under an atmosphere in which the graphene oxide can be reduced. In an embodiment, a surface of the base layer includes an insulator. In an embodiment, the base layer includes a conductive substrate having an insulative film formed thereon. In an embodiment, the conductive substrate is a conductive silicon substrate and the insulative film is a silicon dioxide film. In an embodiment, the base layer is an insulative film and is formed by surface treating the insulative film such that the amino groups are attached thereto. In an embodiment, the method further includes forming an insulative film, and forming the base layer as a separate layer on the insulative film. In an embodiment, forming the reduced graphene oxide layer includes contacting a dispersed solution of graphene oxide on the base layer to form a plurality of islands of carbon atoms. In an embodiment, forming the reduced graphene oxide layer further includes thermally reducing the graphene oxide thereby connecting the plurality of islands of carbon atoms by conductive channels. In an embodiment, the conductive channels have widths of about 10 nm or less. In an embodiment, the islands of carbon atoms are buried in an insulative region of the reduced graphene oxide layer. In an embodiment, the reduced graphene oxide layer has a bandgap of about 0.1 eV or more.

The embodiments provide a field effect transistor having a large on/off ratio and a simple structure using semiconductor graphene oxide at low cost and with high yield. In addition, another embodiment provides a semiconductor graphene oxide having a sufficiently large band gap Eg at low cost and with high yield.

Additional features and advantages are described herein, and will be apparent from the following Detailed Description and the figures.

### BRIEF DESCRIPTION OF THE DRAWINGS

Figs. 1A to 1C are cross-sectional views for explaining a semiconductor graphene oxide manufacturing method according to a first embodiment of the present disclosure;
Fig. 2 is a plan view showing a structure of graphene oxide formed in the semiconductor graphene oxide manufacturing method according to the first embodiment of the present disclosure;
Fig. 3 is a plan view showing a structure of semiconductor graphene oxide formed in the semiconductor graphene oxide manufacturing method according to the first embodiment of the present disclosure;
Fig. 4 is a plan view showing a structure of reduced graphene oxide formed by reducing graphene oxide formed on a substrate without forming a molecular layer including molecules having amino groups.
Fig. 5 is a cross-sectional view showing a field effect transistor according to a second embodiment of the present disclosure;
Figs. 6A to 6C are cross-sectional views for explaining a method of manufacturing the field effect transistor according to the second embodiment of the present disclosure;
Fig. 7 is a schematic diagram showing a result of measurement of a gate voltage-drain current characteristic of a field effect transistor manufactured in Example 3;
Fig. 8 is a schematic diagram showing a result of measurement of an on/off ratio of a field effect transistor manufactured in Example 4;
Fig. 9 is a schematic diagram showing a relationship between the on/off ratio and a carrier mobility of the field effect transistor manufactured in Example 4;
Fig. 10 is a sectional view showing a field effect transistor according to a third embodiment of the present disclosure;
Figs. 11A to 11C are cross-sectional views for explaining a method of manufacturing the field effect transistor according to the third embodiment of the present disclosure; and
Figs. 12A and 12C are cross-sectional views for explaining a method of manufacturing the field effect transistor according to the third embodiment of the present disclosure.

### DETAILED DESCRIPTION

Embodiments will be described in the order below with reference to the attached drawings. The description will be given in order as follows.
1. First embodiment (Semiconductor graphene oxide manufacturing method)
2. Second embodiment (Field effect transistor and method of manufacturing the same)

Hereinafter, modes to carry out the present disclosure (hereinafter referred to as "embodiments") will be described. The description will be given in order as follows.
1. First embodiment (Semiconductor Graphene Oxide Manufacturing Method)
2. Second embodiment (Field Effect Transistor and Method of Manufacturing the Same)
3. Third embodiment (Field Effect Transistor and Method of Manufacturing the Same)

### <1. First Embodiment>

### [Semiconductor Graphene Oxide Manufacturing Method]

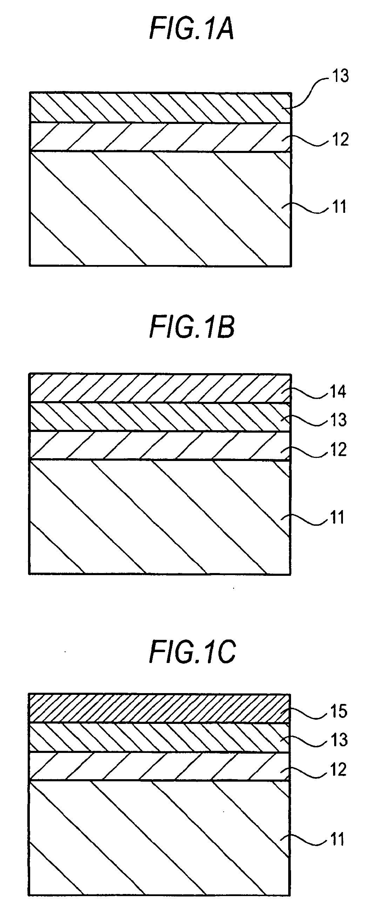

In a first embodiment, first, as shown in Fig. 1A, an insulative film 12 such as a SiO₂ film or the like is formed on a substrate 11 and a molecular layer 13 including molecules having amino groups is formed on the insulative film 12. As the molecules having amino groups, APTMS, APTES and the like may be exemplified. Examples of the substrate 11 may include a silicon substrate, a plastic substrate, a glass substrate, etc.

Next, as shown in Fig. 1B, graphene oxide 14 is formed on the molecular layer 13. Preferably, the graphene oxide 14 is formed by contacting a dispersed solution of graphene oxide to the molecular layer 13. More specifically, for example, the dispersed solution of graphene oxide is applied on the molecular layer 13 or the substrate 11 on which the molecular layer 13 is formed is immersed in the dispersed solution of graphene oxide. Examples of solvents of the dispersed solution of graphene oxide may include water, dimethyl formamide (DMF), ethanol, acetone, tetrahydrofuran (THF), dimethylsulfoxide (DMSO), N-methyl pyrrolidone (NMP), acetonitrile, diethylether, toluene, or a mixture of two or more of these solvents. The dispersed solution of graphene oxide may be applied using spin coating, casting, transferring, or other various printing methods. When the dispersed solution of graphene oxide contacts the molecular layer 13, graphene oxide in the dispersed solution is adhered to the molecular layer 13, thereby forming the graphene oxide 14. Preferably, the thickness of the graphene oxide 14 is equal to or more than 0.3 nm and equal to or less than 10 nm. The concentration of the dispersed solution of graphene oxide or the size of the graphene oxide flakes is not particularly limited and may be selected as necessary.

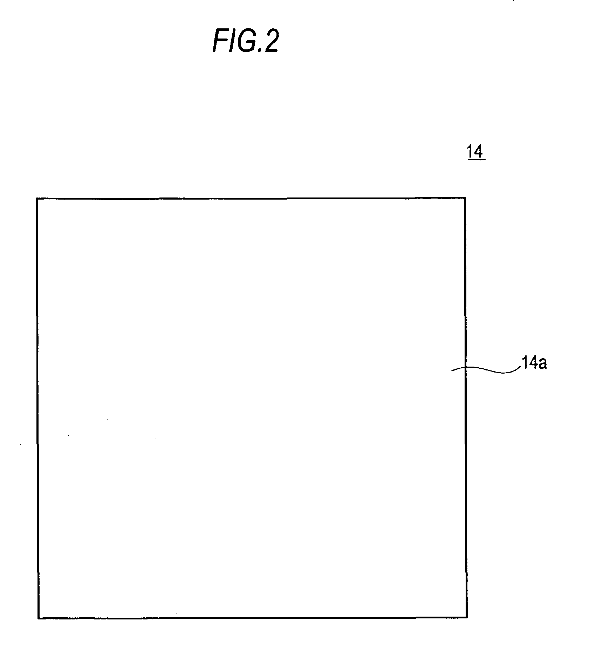

Fig. 2 is a plan view of the graphene oxide 14. As shown in Fig. 2, the graphene oxide 14 includes an insulative region 14a which is made insulative due to disorder in crystallizability, such as oxidation, lattice defects, topological defects and the like.

Next, the graphene oxide 14 is thermally reduced. This forms reduced graphene oxide 15 of a semiconductor (hereinafter referred to as "semiconductor graphene oxide") as shown in Fig. 1C. The graphene oxide 14 is subjected to heat treatment at a temperature of equal to or more than 100°C and equal to or less than 400°C under vacuum, in an inert gas atmosphere or an oxidative gas atmosphere. From the standpoint of improvement of controllability of the band gap Eg, the temperature of heat treatment is preferably equal to or more than 150°C and equal to or less than 300°C, more preferably equal to or more than 180°C and equal to or less than 280°C. Time taken for this heat treatment is equal to or more than 1 minute and equal to or less than 10 hours, although it depends on the heat treatment temperature.

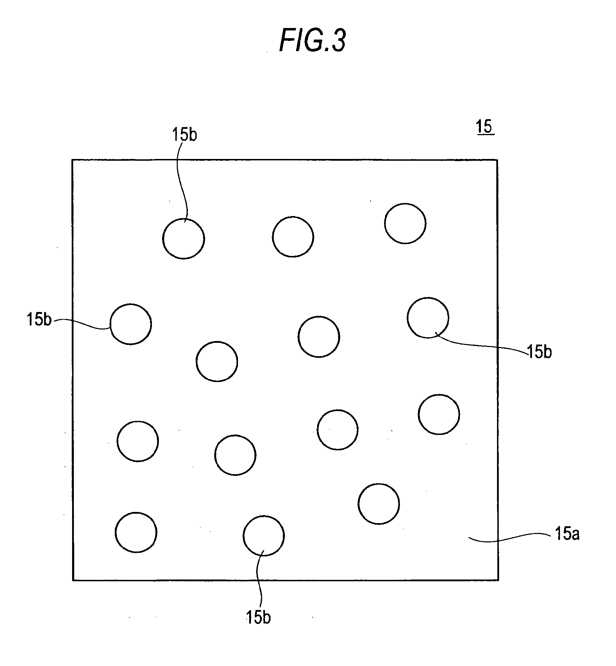

Fig. 3 shows a plan view of the semiconductor graphene oxide 15 obtained by the reduction of the graphene oxide 14. As shown in Fig. 3, in the semiconductor graphene oxide 15, conductive islands 15b of, for example, a size of several nm, which are formed by partial reduction and include carbon atoms combined by a sp² hybrid orbital, are buried in an insulative region 15a which is made insulative by disorder of crystallizability, such as oxidation, lattice defects, topological defects and the like. This semiconductor graphene oxide 15 has a large band gap Eg of, for example, equal to or more than 0.15 eV. A model where a tunnel coupling is generated between one island 15b and another island 15b and electrons are conductive by hopping conduction between one island 15b and the other island 15b may be considered as a conduction model of this semiconductor graphene oxide 15. In addition, a network structure may be formed as the islands 15b are interconnected by a thin conductive channel of a width of, for example, about 10 nm (for example, from 1 nm to 30 nm), including carbon atoms combined by a sp² hybrid orbital, and electrons may be likely to be conductive between one island 15b and the other island 15b via this conductive channel.

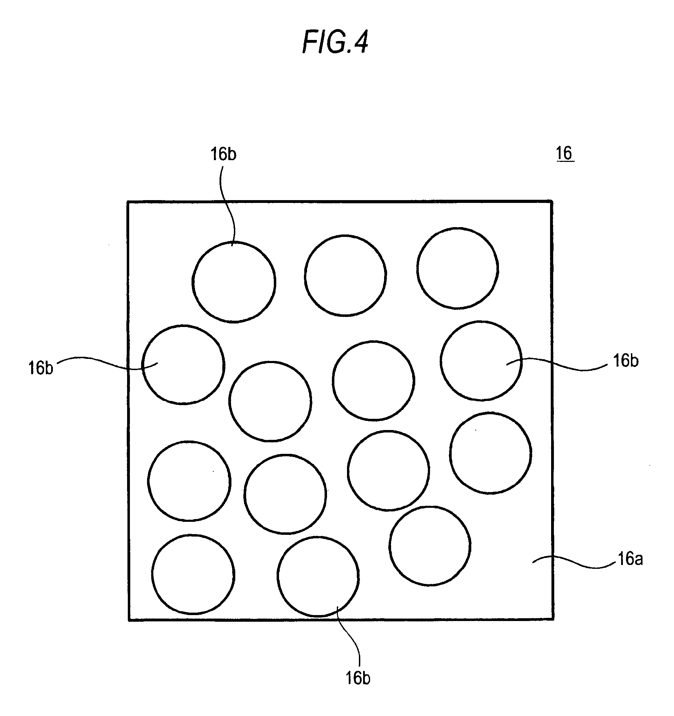

For comparison, Fig. 4 shows reduced graphene oxide 16 obtained by forming the graphene oxide 14 on the substrate 11 without forming the molecular layer 13 including molecules having amino groups, and then thermally or chemically reducing the graphene oxide 14. As shown in Fig. 4, in the reduced graphene oxide 16, the size of the conductive islands 16b which are buried in the insulative region 16a and include carbon atoms combined by a sp² hybrid orbital is significantly larger than the size of the islands 15b buried in the insulative region 15a of the semiconductor graphene oxide 15 shown in Fig. 3. Accordingly, the band gap Eg of this reduced graphene oxide 16 is smaller than the band gap Eg of the semiconductor graphene oxide 15.

### <Example 1>

A p⁺⁺ Si substrate having a 150 nm-thick SiO₂ film formed on its main surface was used as the substrate 11.

APTMS was used as the molecules having amino groups. By immersing the p⁺⁺ Si substrate having the SiO₂ film formed on its main surface in an APTMS (2.7 mM) toluene solution for 15 minutes, a surface of the SiO₂ film was modified with APTMS, thereby forming an APTMS layer.

A graphene oxide dispersed solution of 0.1 mg/ml (with water as a solvent) was prepared and a graphene oxide layer was formed by adhering graphene oxide to the APTMS layer by immersing the p⁺⁺ Si substrate having the APTMS layer formed thereon in the graphene oxide dispersed solution for 5 minutes.

Next, semiconductor graphene oxide was formed by heating and reducing the p⁺⁺ Si substrate having the graphene oxide formed thereon at 250°C for 30 minutes in the atmosphere (with humidity of 60%). As a result of measurement based on a dependency of resistance on temperature, a band gap Eg of the semiconductor graphene oxide was 0.15 eV.

### <Example 2>

A p⁺⁺ Si substrate having a 150 nm-thick SiO₂ film formed on its main surface was used as the substrate 11.

APTMS was used as the molecules having amino groups. By immersing the p⁺⁺ Si substrate having the SiO₂ film formed on its main surface in an APTMS (2.7 mM) toluene solution for 15 minutes, a surface of the SiO₂ film was modified with APTMS, thereby forming an APTMS layer.

A graphene oxide dispersed solution of 0.1 mg/ml (with water as a solvent) was prepared and a graphene oxide layer was formed by adhering graphene oxide to the APTMS layer by immersing the p⁺⁺ Si substrate having the APTMS layer formed thereon in the graphene oxide dispersed solution for 5 minutes.

Next, semiconductor graphene oxide was formed by heating and reducing the p⁺⁺ Si substrate having the graphene oxide layer formed thereon at 250°C for 1 hour in an atmosphere including substantially no water (with oxygen concentration of 19% and a dew point of -30°C). As a result of measurement based on a dependency of resistance on temperature, the band gap Eg of the semiconductor graphene oxide was 0.25 eV.

As described above, according to the first embodiment, the semiconductor graphene oxide 15 can be easily formed by forming the molecular layer 13 on the insulative film 12 on the substrate 11, forming the graphene oxide 14 thereon, and then thermally reducing the graphene oxide 14. The semiconductor graphene oxide 15 has a band gap Eg of 0.15 eV or more, which is sufficiently large for practical use. In addition, since the graphene oxide 14 can be formed with a large area, large area semiconductor graphene oxide 15 can be formed. In addition, since the graphene oxide 14, being a raw material of the semiconductor graphene oxide 15, is extremely inexpensive, the semiconductor graphene oxide 15 can be obtained at low cost. In addition, since there is no need to thin a graphene sheet or use two-layered graphene as disclosed in "Energy Band-Gap Engineering of Graphene Nanoribbons," Phys. Rev. Lett. 98, 206805 (2007), "Chemically Derived, Ultrasmooth Graphene Nanoribbon Semiconductors," Science 319, 1229 (2008) and "Direct Observation of a Widely Tunable Bandgap in Bilayer Graphene," Nature 459, 820 (2009), large area semiconductor graphene oxide 15 can be obtained at low cost and with high yield. Moreover, since the molecular layer 13 including the molecules having amino groups and the graphene oxide 14 can be formed by means of a solution process, it is possible to achieve reduction in the production cost of the semiconductor graphene oxide 15.

### <2. Second Embodiment>

### [Field Effect Transistor]

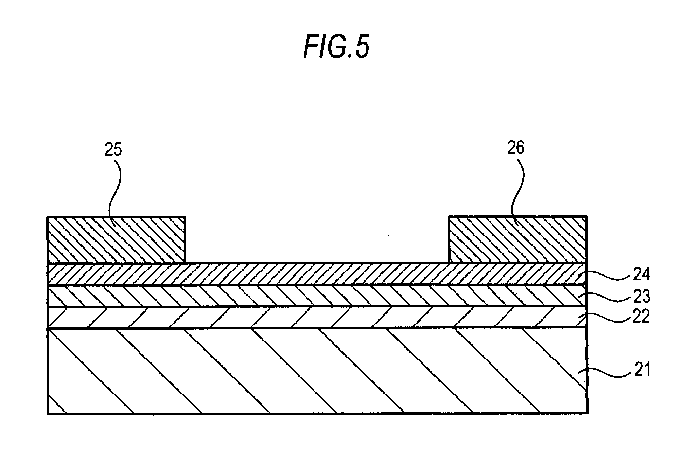

Fig. 5 shows a field effect transistor according to a second embodiment. The field effect transistor shown has a bottom gate structure.

As shown in Fig. 5, in the field effect transistor, a gate insulative film 22 is formed on a conductive substrate 21 constituting a gate electrode. Examples of the conductive substrate 21 may include a conductive Si substrate, a conductive plastic substrate, a metallic substrate, etc. Examples of the gate insulative film 22 may include an inorganic insulative film such as a SiO₂ film, a silicon nitride (SiN) film or the like, a polymer insulative film such as polyvinyl phenol, etc. A molecular layer 23 including molecules having amino groups is formed on the gate insulative film 22. Examples of the molecules having amino groups may include APTMS, APTES, etc. In addition, as a channel layer, semiconductor graphene oxide 24 is formed on the molecular layer 23. The semiconductor graphene oxide 24 has the same structure as the semiconductor graphene oxide 15 shown in Fig. 3. A source electrode 25 and a drain electrode 26 are formed on the semiconductor graphene oxide 24. The source electrode 25 and the drain electrode 26 are made of metal such as palladium (Pd), platinum (Pt), nickel (Ni), titanium (Ti), chromium (Cr), aluminum (Al), gold (Au), silver (Ag), copper (Cu) or the like, graphite, graphene, carbon nanotubes, conductive polymer, or other various conductive materials, and may be selected as necessary.

### [Field Effect Transistor Manufacturing Method]

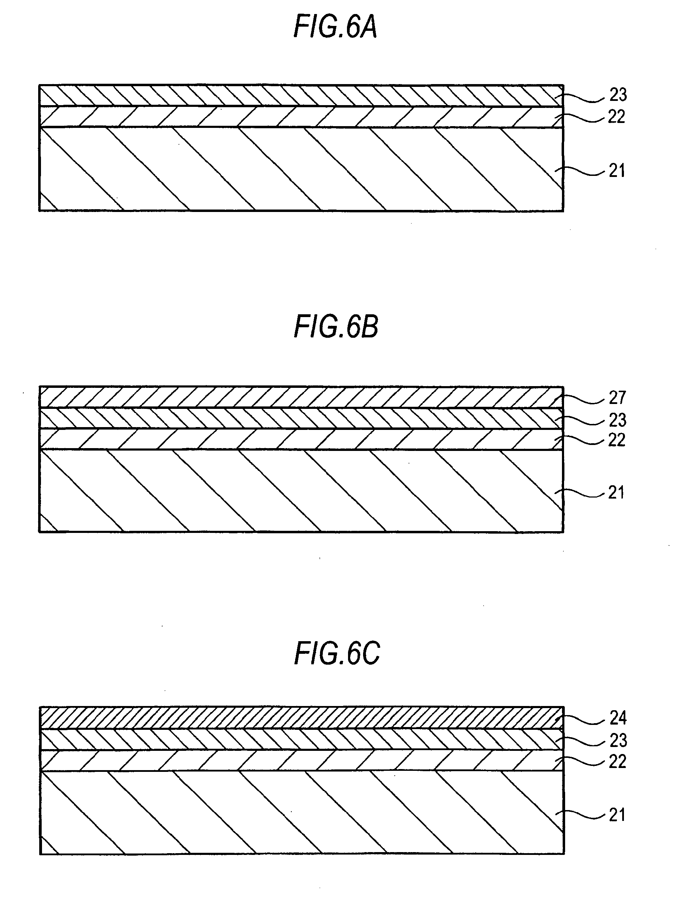

First, as shown in Fig. 6A, the molecular layer 23 including the molecules having amino groups is formed on the gate insulative film 22 formed on the conductive substrate 21.

Next, as shown in Fig. 6B, graphene oxide 27 is formed on the molecular layer 23 on the gate insulative film 22. As in the first embodiment, the graphene oxide 27 may be formed by contacting a dispersed solution of graphene oxide to the molecular layer 23 and then adhering graphene oxide in the dispersed solution to the molecular layer 23.

Next, as in the first embodiment, the semiconductor graphene oxide 24 is formed by thermally reducing the graphene oxide 27, as shown in Fig. 6C.

Next, as shown in Fig. 5, the source electrode 25 and the drain electrode 26 are formed on the semiconductor graphene oxide 24. The source electrode 25 and the drain electrode 26 may be formed by forming a conductive layer (not shown) such as metal and then patterning the conductive layer into a predetermined shape using lithography and etching processes or patterning a conductive layer (not shown) having a predetermined shape using a lift-off method, a printing process or the like.

In this manner, the intended field effect transistor can be manufactured.

### <Example 3>

A p⁺⁺ Si substrate having a 150 nm-thick SiO₂ film formed on its main surface was used as the substrate 21.

APTMS was used as the molecules having amino groups. By immersing the p⁺⁺ Si substrate having the SiO₂ film formed on its main surface in an APTMS (2.7 mM) toluene solution for 15 minutes, a surface of the SiO₂ film is modified with APTMS, thereby forming an APTMS layer.

A graphene oxide dispersed solution (of 0.1 mg/ml) (with water as a solvent) was prepared and a graphene oxide was formed by adhering graphene oxide to the APTMS layer by immersing the p⁺⁺ Si substrate having the APTMS layer formed thereon in the graphene oxide dispersed solution for 5 minutes.

Next, semiconductor graphene oxide was formed by heating and reducing the p⁺⁺ Si substrate having the graphene oxide layer formed thereon at 250°C for 30 minutes in the atmosphere (with humidity of 60%).

Next, after forming a resist pattern (not shown) having a predetermined shape on the semiconductor graphene oxide using photolithography, a Pd film was formed using a vacuum deposition process. Next, the excess of the Pd film and resist were removed using a lift-off method to thereby form the source electrode 25 and the drain electrode 26 constituted by the Pd film.

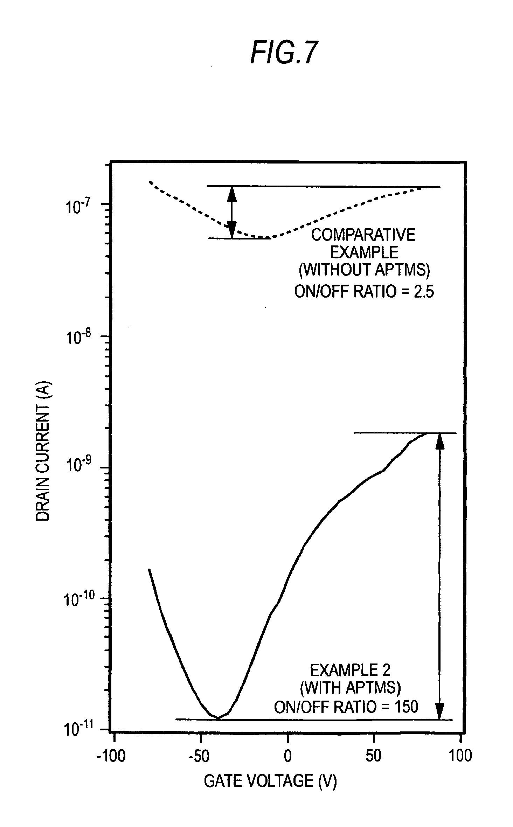

Fig. 7 shows a result of measurement (in room temperature) of a gate voltage-drain current characteristic of the field effect transistor having the bottom gate structure manufactured thus. Here, the channel length of the field effect transistor was 6 µm, and the channel width thereof was 900 µm. For comparison, Fig. 7 also shows a result of measurement in room temperature of a gate voltage-drain current characteristic of a field effect transistor having a bottom gate structure manufactured in the same way as the above-described method except that the graphene oxide 27 is formed on the gate insulative film 22 without forming an APTMS layer. It can be seen from Fig. 7 that an on/off ratio of the field effect transistor having the bottom gate structure manufactured without forming the APTMS layer is small, being 2.5, whereas an on/off ratio of the field effect transistor having the bottom gate structure manufactured with the APTMS layer formed on the gate insulative film 22 is extremely large, being 150. In addition, as a result of measurement based on a dependency of drain current on temperature, a band gap Eg of the semiconductor graphene oxide was 0.15 eV.

Such a large on/off ratio is attributed to a significant decrease of off-current Ioff of the field effect transistor due to a large band gap Eg of 0.15 eV of the semiconductor graphene oxide. That is, as Eg of the semiconductor graphene oxide increases, thermally-excited carriers decrease and accordingly the off-current Ioff decreases. More specifically, a relationship between the off-current Ioff and the band gap Eg of the field effect transistor is represented by Ioff α exp(-Eg/2kBT). Here, kB is the Boltzmann constant and T is temperature.

### <Example 4>

A p⁺⁺ Si substrate having a 150 nm-thick SiO₂ film formed on its main surface was used as the substrate 21.

APTMS was used as the molecules having amino groups. By immersing the p⁺⁺ Si substrate having the SiO₂ film formed on its main surface in an APTMS (2.7 mM) toluene solution for 15 minutes, a surface of the SiO₂ film was modified with APTMS, thereby forming an APTMS layer.

A graphene oxide dispersed solution of 0.1 mg/ml (with water as a solvent) was prepared and a graphene oxide was formed by adhering graphene oxide to the APTMS layer by immersing the p⁺⁺ Si substrate having the APTMS layer formed thereon in the graphene oxide dispersed solution for 5 minutes.

Next, semiconductor graphene oxide was formed by heating and reducing the p⁺⁺ Si substrate having the graphene oxide layer formed thereon at 250°C for 1 hour in an atmosphere including substantially no water (with oxygen concentration of 19% and a dew point of -30°C).

Next, after forming a resist pattern (not shown) having a predetermined shape on the semiconductor graphene oxide using photolithography, a Cr film and an Au film were formed in order using a vacuum deposition process. Next, the excess of the Cr film, Au film and resist were removed using a lift-off method to thereby form the source electrode 25 and the drain electrode 26 constituted by the Cr/Au film.

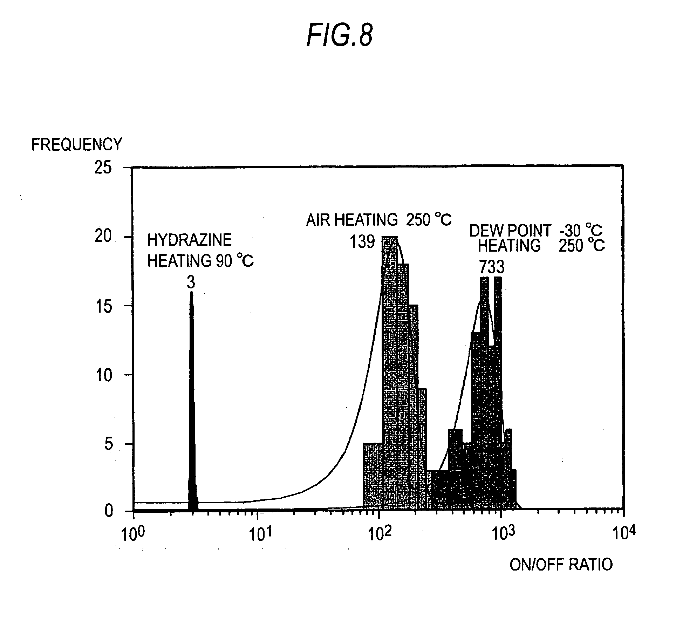

A plurality of field effect transistors having a bottom gate structure were manufactured according to the above-described process. A transfer characteristic of these field effect transistors was measured with application of a drain voltage of 1 V and a gate voltage of a range of from 100 V to -100 V. Fig. 8 shows a frequency distribution of an on/off ratio obtained from the measured transfer characteristic. It was assumed that channel length and width of each field effect transistor were 6 µm and 900 µm, respectively. For comparison, Fig. 8 also shows the same frequency distribution of field effect transistors having a bottom gate structure manufactured according to the same above-described process except that semiconductor graphene oxide was formed by performing a heating and reducing process at 250°C for 1 hour in an atmosphere (with humidity of 60% and oxygen concentration of 19%). In addition, Fig. 8 also shows the same frequency distribution of field effect transistors having a bottom gate structure manufactured according to the same above-described process except that graphene oxide is chemically reduced at 90°C in a hydrazine atmosphere and then absorbed on the APTMS layer. As shown in Fig. 8, while an on/off ratio (a mean value) when the graphene oxide is chemically reduced at 90°C in the hydrazine atmosphere and then absorbed on the APTMS layer is small, i.e., 3, an on/off ratio (a mean value) when semiconductor graphene oxide is formed by a heating and reducing process at 250°C for 1 hour in air is 139, i.e., increases by about 48 times. In addition, when the semiconductor graphene oxide is formed by performing the heating and reducing process at 250°C for 1 hour in an atmosphere of a dew point of -30°C including substantially no water, an on/off ratio (a mean value) is extremely large, i.e., 733, which is an increase by about five times over the on/off ratio when the semiconductor graphene oxide is formed by the heating and reducing process at 250°C for 1 hour in air. It was noted that a noticeably large on/off ratio of equal to or more than 1000 is obtained when the semiconductor graphene oxide is formed by performing the heating and reducing process at 250°C for 1 hour in an atmosphere of a dew point of -30°C including substantially no water. A curve in Fig. 8 represents a correlation using a Gaussian function.

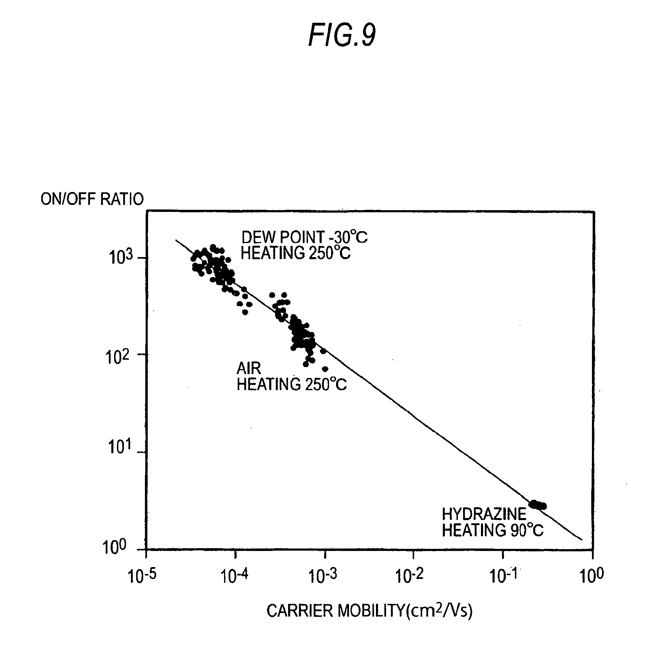

Fig. 9 is a diagram showing a relationship between an on/off ratio and a carrier mobility of the field effect transistor including the semiconductor graphene oxide or reduced graphene oxide formed by performing the reduction of the graphene oxide according to the three above-described processes. As can be seen from Fig. 9, a smaller carrier mobility provides a larger on/off ratio. This may explain that the carrier mobility becomes smaller since its size is proportional to the size of conductive islands formed by the reduction of the graphene oxide and a smaller island size provides a larger distance between one island and another, while the on/off ratio becomes larger since the semiconductor graphene oxide or the reduced graphene oxide includes more insulative portions. In addition, due to the fact that a characteristic is insignificantly changed even when the heating and reducing time is changed from 1 hour to 5 minutes, it can be seen that the heating and reduction of the graphene oxide on the APTMS layer has a special state in which the graphene oxide is no longer reduced after it is reduced by a predetermined amount. The amount of reduction provides a feature of good controllability since it is determined by an atmosphere (oxygen atmosphere, etc.) of a base layer and a surface of the APTMS layer or the like.

As described above, according to the second embodiment, the semiconductor graphene oxide 24 can be formed by forming the graphene oxide 27 on the molecular layer 23 on the gate insulative film 22 on the conductive substrate 21 and then thermally reducing the graphene oxide 27. The semiconductor graphene oxide 24 has a band gap Eg of 0.15 eV or more, which is sufficiently large for practical use. This makes it possible to realize a field effect transistor whose leak current is significantly decreased due to a decrease in an off-current Ioff. When this field effect transistor is used for a logic circuit, it is possible to significantly decrease power consumption of the logic circuit. In addition, since an on/off ratio of this field effect transistor is extremely large, being 150 or more, or 1000 of more, when this field effect transistor is used for a backplane of a display, it is possible to realize a display having a large contrast ratio of luminance. In addition, since the semiconductor graphene oxide 24 can be formed at low cost and with a large area, it is possible to manufacture field effect transistors at low cost. In addition, by using a field effect transistor having a extremely large on/off ratio, it is possible to realize a chemical sensor, a bio sensor and the like having very high sensitivity.

### <3. Third Embodiment>

### [Field Effect Transistor]

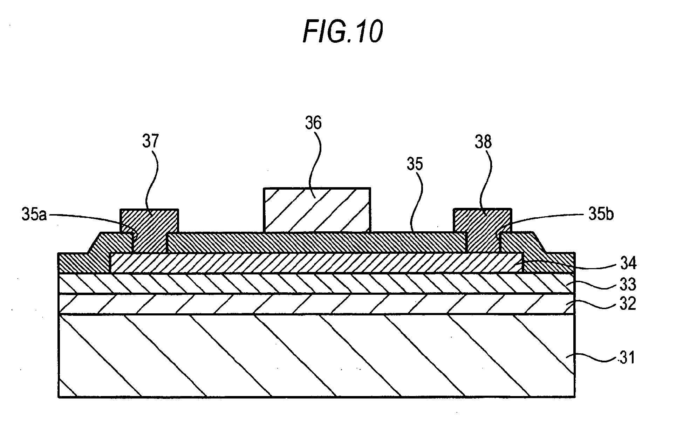

Fig. 10 shows a field effect transistor according to a third embodiment. The field effect transistor shown has a top gate structure.

As shown in Fig. 10, in the field effect transistor, a insulative film 32 such as a SiO₂ film or the like is formed on a substrate 31, and a molecular layer 33 including molecules having amino groups is formed thereon. Examples of the substrate 31 may include a Si substrate, a plastic substrate, etc. Examples of the molecules having amino groups may include APTMS, APTES, etc. Semiconductor graphene oxide 34 of a predetermined shape is formed on the molecular layer 33. The semiconductor graphene oxide 34 has the same structure as the semiconductor graphene oxide 15 shown in Fig. 3. A gate insulative film 35 is formed to cover the semiconductor graphene oxide 34. Examples of the gate insulative film 35 may include a SiO₂ film, a SiN film or the like. A gate electrode 36 is formed on the gate insulative film 35. The gate electrode 36 may be made of, for example, aluminum (Al) or the like. Openings 35a and 35b are formed in the gate insulative film 35 over both end portions of the semiconductor graphene oxide 34, respectively. A source electrode 37 and a drain electrode 38 contact the semiconductor graphene oxide 34 through the openings 35a and 35b on the semiconductor graphene oxide 15, respectively. The source electrode 37 and the drain electrode 38 are made of the same conductive materials as the source electrode 25 and the drain electrode 26, and may be selected as necessary.

### [Field Effect Transistor Manufacturing Method]

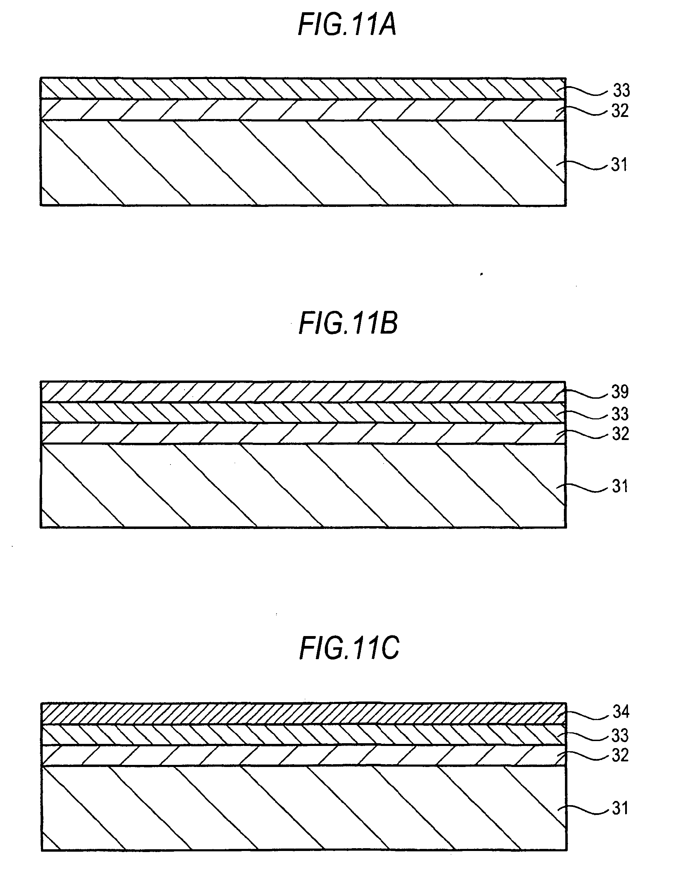

First, as shown in Fig. 11A, the molecular layer 33 including the molecules having amino groups is formed on the gate insulative film 32 formed on the substrate 31.

Next, as shown in Fig. 11B, graphene oxide 39 is formed on the molecular layer 33. As in the first embodiment, the graphene oxide 39 may be formed by contacting a dispersed solution of graphene oxide to the molecular layer 33 and then adhering graphene oxide in the dispersed solution to the molecular layer 33.

Next, as in the first embodiment, the semiconductor graphene oxide 34 is formed by thermally reducing the graphene oxide 39, as shown in Fig. 11C.

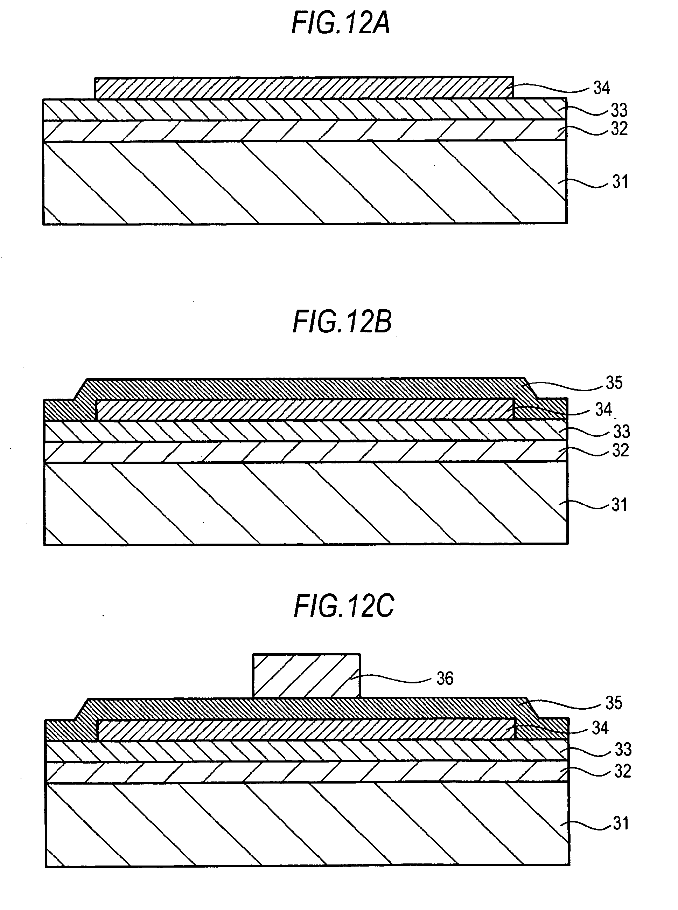

Next, as shown in Fig. 12A, the semiconductor graphene oxide 34 is patterned into a predetermined shape using lithography and a reactive ion etching process using an oxygen gas or the like.

Next, as shown in Fig. 12B, the gate insulative film 35 is formed to cover the entire surface of the semiconductor graphene oxide 34.

Next, as shown in Fig. 12C, the gate electrode 36 is formed on the gate insulative film 35. The gate electrode 36 may be formed by forming a film made of a gate electrode material using, for example, a vacuum deposition process or the like and then patterning this film into a predetermined shape using lithography.

Next, as shown in Fig. 10, a predetermined portion of the gate insulative film 35 is etched away to form the openings 35a and 35b.

Thereafter, after forming a conductive layer (not shown) made of metal or the like on the entire surface, the source electrode 37 and the drain electrode 38 are formed in the openings 35a and 35b by patterning the conductive layer into a predetermined shape using lithography.

In this manner, the intended field effect transistor is manufactured.

The third embodiment provides the field effect transistor having the top gate structure, which has the same advantages as in the second embodiment.

The present application contains subject matter related to those disclosed in Japanese Priority Patent Applications JP 2010-125653 and JP 2010-263171 filed in the Japan Patent Office on June 1, 2010 and November 26, 2010, respectively.

Support for the claims are defined in the following itemized list:
1. A film comprising:
   a base layer having amino groups; and
   a reduced graphene oxide layer formed on the base layer.
2. The film according to item 1, wherein a surface of the base layer includes an insulator.
3. The film according to item 2, wherein the base layer comprises a conductive substrate having an insulative film formed thereon.
4. The film according to item 3, wherein the conductive substrate is a conductive silicon substrate and the insulative film is a silicon dioxide film.
5. The film according to item 1, wherein the base layer is an insulative film that has been surface treated such that the amino groups are attached thereto.
6. The film according to Claim 1, further comprising an insulative film, wherein the base layer is formed as a separate layer on the insulative film.
7. The film according to item 1, wherein the amino groups are in the form of APTMS or APTES.
8. The film according to item 1, wherein a thickness of the reduced graphene oxide layer ranges from about 0.3 nm to about 10 nm.
9. The film according to item 1, wherein the reduced graphene oxide layer includes a plurality of islands, the islands including carbon atoms combined by an sp² hybrid orbital.
10. The film according to item 9, wherein the islands are buried in an insulative region of the reduced graphene oxide layer.
11. The film according to item 9, wherein the plurality of islands are interconnected by a plurality of conductive channels to form a network structure within the reduced graphene oxide layer.
12. The film according to item 11, wherein the conductive channels have widths of about 10 nm or less.
13. The film according to item 1, wherein the reduced graphene oxide layer has a bandgap of about 0.1 eV or more.
14. A reduced graphene oxide layer including a plurality of islands of carbon atoms, wherein the plurality of islands are interconnected by a plurality of conductive channels to form a network structure, the conductive channels having a width of about 10 nm or less.
15. The reduced graphene oxide layer according to item 14, wherein a thickness of the reduced graphene oxide layer ranges from about 0.3 nm to about 10 nm.
16. The reduced graphene oxide layer according to item 14, wherein the reduced graphene oxide layer includes a plurality of islands, the islands including carbon atoms combined by an sp² hybrid orbital.
17. The reduced graphene oxide layer according to item 14, wherein the islands are buried in an insulative region of the reduced graphene oxide layer.
18. The reduced graphene oxide layer according to item 14, wherein the reduced graphene oxide layer has a bandgap of about 0.1 eV or more.
19. A semiconductor device comprising:
   a conductive substrate;
   an insulating film formed on the conductive substrate;
   a base layer including amino groups; and
   a reduced graphene oxide layer formed on the base layer.
20. The semiconductor device according to item 19, wherein the conductive substrate is a conductive silicon substrate and the insulating film is a silicon dioxide film.
21. The semiconductor device according to item 20, further comprising a source electrode and a gate electrode formed on the reduced graphene oxide layer.
22. The semiconductor device according to item 21, wherein the semiconductor device is a field effect transistor.
23. The semiconductor device according to item 19, further comprising:
   a second gate insulating film covering the reduced graphene oxide layer, the second gate insulating film including openings exposing portions of the reduced graphene oxide layer;
   a source electrode formed in a first one of the openings;
   a drain electrode formed in a second one of the openings; and
   a gate electrode formed on the second gate insulating film.
24. The semiconductor device according to item 19, wherein the amino groups are in the form of APTMS or APTES.
25. The semiconductor device according to item 19, wherein a thickness of the reduced graphene oxide layer ranges from about 0.3 nm to about 10 nm.
26. The semiconductor device according to item 19, wherein the reduced graphene oxide layer includes a plurality of islands, the islands including carbon atoms combined by an sp² hybrid orbital.
27. The semiconductor device according to item 26, wherein the islands are buried in an insulative region of the reduced graphene oxide layer.
28. The semiconductor device according to item 26, wherein the plurality of islands are interconnected by a plurality of conductive channels to form a network structure within the reduced graphene oxide layer.
29. The semiconductor device according to item 26, wherein the conductive channels have widths of about 10 nm or less.
30. The semiconductor device according to item 19, wherein the reduced graphene oxide layer has a bandgap of about 0.1 eV or more.
31. A method of manufacturing a film, the method comprising:
   forming a base layer including amino groups; and
   forming a reduced graphene oxide layer on the base layer.
32. The method of manufacturing a film according to item 31, wherein the reduced graphene oxide layer is formed by thermally or chemically reducing graphene oxide.
33. The method of manufacturing a film according to item 32, wherein the reduced graphene oxide layer is formed by reducing graphene oxide by heat treatment at a temperature of equal to or more than 100°C and equal to or less than 400°C under an atmosphere in which the graphene oxide can be reduced.
34. The method of manufacturing a film according to item 33, wherein a surface of the base layer includes an insulator.
35. The method of manufacturing a film according to item 34, wherein the base layer comprises a conductive substrate having an insulative film formed thereon.
36. The method of manufacturing a film according to item 35, wherein the conductive substrate is a conductive silicon substrate and the insulative film is a silicon dioxide film.
37. The method of manufacturing a film according to item 31, wherein the base layer is an insulative film and is formed by surface treating the insulative film such that the amino groups are attached thereto.
38. The method of manufacturing a film according to item 31, further comprising forming an insulative film, and forming the base layer as a separate layer on the insulative film.
39. The method of manufacturing a film according to item 31, wherein forming the reduced graphene oxide layer includes contacting a dispersed solution of graphene oxide on the base layer to form a plurality of islands of carbon atoms.
40. The method of manufacturing a film according to item 39, wherein forming the reduced graphene oxide layer further includes thermally or chemically reducing the graphene oxide thereby connecting the plurality of islands of carbon atoms by conductive channels.
41. The method of manufacturing a film according to item 40, wherein the conductive channels have widths of about 10 nm or less.
42. The semiconductor device according to item 39, wherein the islands of carbon atoms are buried in an insulative region of the reduced graphene oxide layer.
43. The semiconductor device according to item 36, wherein the reduced graphene oxide layer has a bandgap of about 0.1 eV or more.
44. A method of forming a reduced graphene oxide layer, the method comprising:
   forming a plurality of islands of carbon atoms; and
   interconnecting the plurality of islands of carbon atoms with a plurality of conductive channels to form a network structure of the graphene oxide layer,
   wherein the conductive channels have a width of about 10 nm or less.
45. The method of forming a reduced graphene oxide layer according to item 44, wherein the reduced graphene oxide layer is formed by thermally or chemically reducing graphene oxide.
46. The method of forming a reduced graphene oxide layer according to item 45, wherein the reduced graphene oxide layer is formed by reducing graphene oxide by heat treatment at a temperature of equal to or more than 100°C and equal to or less than 400°C under an atmosphere in which the graphene oxide can be reduced.
47. A method of manufacturing a semiconductor device, the method comprising:
   providing a conductive substrate;
   forming an insulating film on the conductive substrate;
   forming a layer including amino groups on the insulating film; and
   forming a reduced graphene oxide layer on the layer including amino groups.
48. The method of manufacturing a semiconductor device according to item 47, wherein the reduced graphene oxide layer is formed by thermally or chemically reducing graphene oxide.
49. The method of manufacturing a semiconductor device according to item 48, wherein the reduced graphene oxide layer is formed by reducing graphene oxide by heat treatment at a temperature of equal to or more than 100°C and equal to or less than 400°C under an atmosphere in which the graphene oxide can be reduced.
50. The method of manufacturing a semiconductor device according to item 49, wherein the conductive substrate is a conductive silicon substrate and the insulating film is a silicon dioxide film.
51. The method of manufacturing a semiconductor device according to item 50, further comprising forming a source electrode and a drain electrode on the reduced graphene oxide layer.

## Claims

1. Method of manufacturing a film, the method comprising:
forming a base layer including amino groups; and
forming a reduced graphene oxide layer on the base layer,
wherein the reduced graphene oxide layer is formed by thermally reducing graphene oxide, said graphene oxide being subjected to a heat treatment at a temperature equal to or more than 100°C and equal to or less than 400°C under vacuum, in an inert gas atmosphere or an oxidative gas atmosphere, the time taken for this heat treatment being equal to or more than 1 minute and equal to or less than 10 hours.

2. Method according to claim 1, wherein said graphene oxide is subjected to a heat treatment equal to or more than 150°C and equal to or less than 300°C.

3. Method according to claim 2, wherein said graphene oxide is subjected to a heat treatment equal to or more than 180°C and equal to or less than 280°C.

4. Method according to anyone of claims 1 to 3, wherein the base layer is an insulative film that has been surface treated such that the amino groups are attached thereto.

## Patentansprüche

1. Verfahren zum Herstellen einer Schicht, wobei das Verfahren enthält:
Ausbilden einer Basislage, die Aminogruppen enthält; und
Ausbilden einer Lage von reduziertem Graphenoxid auf der Basislage,
wobei die Lage von reduziertem Graphenoxid durch thermisches Reduzieren von Graphenoxid ausgebildet wird, wobei das Graphenoxid bei einer Temperatur gleich oder größer als 100 °C und gleich oder kleiner als 400 °C unter Unterdruck in einer Inertgasatmosphäre oder in einer Atmosphäre eines oxidierenden Gases einer Wärmebehandlung ausgesetzt wird, wobei die Zeit, die diese Wärmebehandlung dauert, gleich oder größer 1 Minute und gleich oder kleiner 10 Stunden ist.

2. Verfahren nach Anspruch 1, wobei das Graphenoxid einer Wärmebehandlung von gleich oder größer 150 °C und gleich oder kleiner 300 °C ausgesetzt wird.

3. Verfahren nach Anspruch 2, wobei das Graphenoxid einer Wärmebehandlung von gleich oder größer 180 °C und gleich oder kleiner 280 °C ausgesetzt wird.

4. Verfahren nach einem der Ansprüche 1 bis 3, wobei die Basislage eine Isolierlage ist, die in der Weise oberflächenbehandelt worden ist, dass die Aminogruppen daran befestigt werden.

## Revendications

1. Procédé de fabrication d'un film, le procédé comprenant :
la formation d'une couche de base incluant des groupes amino ; et
la formation d'une couche d'oxyde de graphène réduit sur la couche de base,
dans lequel la couche d'oxyde de graphène réduit est formée par réduction thermique de l'oxyde de graphène, ledit oxyde de graphène étant soumis à un traitement thermique à une température supérieure ou égale à 100 °C et inférieure ou égale à 400 °C sous vide, sous une atmosphère de gaz inerte ou une atmosphère de gaz oxydant, le temps nécessaire pour ce traitement thermique étant supérieur ou égal à 1 minute et inférieur ou égal à 10 heures.

2. Procédé selon la revendication 1, dans lequel ledit oxyde de graphène est soumis à un traitement thermique à une température supérieure ou égale à 150 °C et inférieure ou égale à 300 °C.

3. Procédé selon la revendication 2, dans lequel ledit oxyde de graphène est soumis à un traitement thermique à une température supérieure ou égale à 180 °C et inférieure ou égale à 280 °C.

4. Procédé selon l'une quelconque des revendications 1 à 3, dans lequel la couche de base est un film isolant qui a été traité en surface de sorte que les groupes amino y soient attachés.
